# EUROPEAN PATENT APPLICATION

(11) **EP 2 374 913 A1**
(43) Date of publication of application: **12.10.2011**
(21) Application number: 11161121.6
(22) Date of filing: 05.04.2011
(51) Int. Cl.: C23C 14/02, C23C 14/54, F01D 5/28

(54) **Deposition apparatus with preheating chamber having thermal hood**

(30) Priority: 12.04.2010 US 758199
(71) Applicant: United Technologies Corporation, Hartford, CT 06101 (US)
(72) Inventor: Neal, James W., Ellington, CT 06029 (US)
(74) Representative: Leckey, David Herbert

(57) **Abstract**

A deposition apparatus (10) includes a coating chamber (14) operative to deposit a coating on workpieces (12). A preheating chamber (16) is located adjacent to the coating chamber (14) and includes a heating zone (20) receiving the workpieces (12). A heating source (18) is operative to provide heat to the heating zone (20). A thermal hood (22) within the preheating chamber (16) is located adjacent to the heating zone (20) and operative to control a temperature of the heating zone (20).

## Description

### BACKGROUND

This disclosure relates to a deposition apparatus with a preheating chamber having a thermal hood for improved temperature control within a heating zone.

Physical vapor deposition ("PVD") is one method for coating substrates, such as gas turbine engine airfoils. Prior to deposition of the coating, the substrates may be heated in a preheating chamber to produce a thermally grown oxide surface layer that facilitates adhesion with the coating. The preheating chamber typically includes graphite heating elements to heat the substrates to a predetermined temperature. A PVD process, such as Electron Beam Physical Vapor Deposition ("EB-PVD"), may then utilize an electron beam gun to melt and vaporize a source material within a coating chamber and deposit the source material onto the thermally grown oxide surface layers of the substrates.

### SUMMARY

An exemplary deposition apparatus includes a coating chamber operative to deposit a coating on workpieces. A preheating chamber is located adjacent to the coating chamber and includes a heating zone receiving the workpieces. A heating source is operative to provide heat to the heating zone. A thermal hood within the preheating chamber is located adjacent to the heating zone and operative to control a temperature of the heating zone.

In another aspect, the heating source of the deposition apparatus may include a ceramic media within the preheating chamber. At least one electron being source is operative for emitting an electron beam onto the media to generate heat. A semi-cylindrical thermal hood within the preheating chamber may at least partially surround the heating zone for controlling a temperature of the heating zone.

An exemplary method for use with a deposition apparatus includes controlling a temperature within a heating zone in a preheating chamber of a deposition apparatus using a thermal hood that is adjacent to the heating zone.

### BRIEF DESCRIPTION OF THE DRAWINGS

The various features and advantages of the disclosed examples will become apparent to those skilled in the art from the following detailed description. The drawings that accompany the detailed description can be briefly described as follows.
Figure 1 illustrates an example preheating chamber having a thermal hood.
Figure 2 illustrates an example deposition apparatus.
Figure 3 illustrates an example thermal hood.
Figure 4 illustrates another example deposition apparatus.

### DETAILED DESCRIPTION OF THE PREFERRED EMBODIMENT

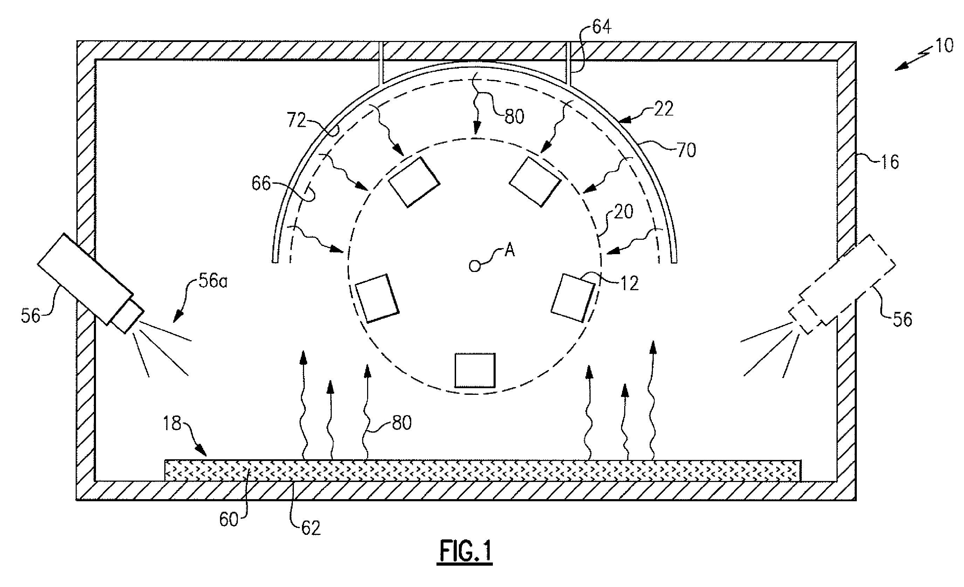

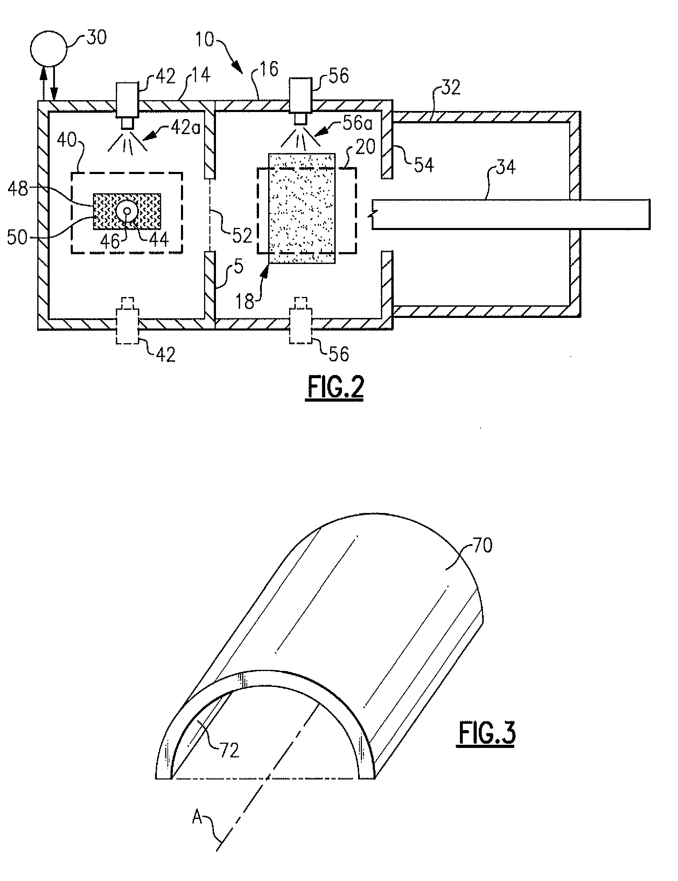

Figures 1 and 2 illustrate selected portions of an example deposition apparatus 10 for depositing a coating on one or more workpieces 12 via physical vapor deposition ("PVD"). In the illustrated examples, the deposition apparatus 10 may be adapted for electron beam PVD ("EB-PVD"), electron beam directed vapor deposition ("EB-DVD"), or both, although it is to be understood that other types of deposition equipment may also benefit from the disclosed examples.

As can be appreciated, the workpieces 12 are not limited to any particular type. In some examples, the workpieces 12 may be gas turbine engine components, such as airfoils (e.g., blades and vanes). Additionally, the type of coating deposited may be any desired coating that is suitable for vapor deposition. As an example, the coating may be a ceramic thermal barrier coating and may include ceramic materials such as gadolinia, zirconia, yttria, hafnia, or combinations thereof. The ceramic materials may be in a solid solution or compound. A few examples include gadolinia-zirconia, gadolinia-hafnia, or other solid solutions or compounds based on zirconium or hafnium, such as those including lanthanide elements, scandium, indium, yttrium, molybdenum, carbon, magnesium, or rare earth oxides. Other examples may include gadolinium zirconate or hafnium zirconate. Gadolinia stabilize zirconia ("GSZ") or yttria stablizined zirconia ("YSZ").

In general, the deposition apparatus 10 may facilitate depositing the coating on angled surfaces and non-line-of-site surfaces of a workpiece and/or may be used to deposit a multi-layer coating with layers of similar or different compositions. In any case, the workpieces may be heated in a preheating chamber prior to coating, as will be discussed below, to provide a thermally grown oxide that facilitates bonding with the coating.

As an example, the workpieces may include an aluminum-containing bond coat that is deposited on the metallic substrate of the workpiece. The bond coat may be any suitable type of bond coat that facilitates bonding. In some examples, the bond coat may be a metal-chromium-aluminum-yttrium layer ("MCrAlY"), an aluminide or platinum aluminide material, or a lower-aluminum gamma/gamma prime-type coating.

In the presence of oxygen gas, the aluminum from the bond coat forms an oxide. The type of oxide that forms depends, at least in part, upon the processing temperature. For instance, the coating chamber 14 provides the ability to tightly control the temperature in the preheating chamber to facilitate forming a desired type of the thermally grown oxide.

Referring to Figure 2, the deposition apparatus 10 includes a coating chamber 14 that is operative to coat the workpieces 12 during a coating process and a preheating chamber 16 that is located adjacent to the coating chamber 14. The coating chamber 14 and the preheating chamber 16 may be vacuum chambers and may include various ports for evacuating the interiors of the chambers or for selectively introducing gases that are to be used in the process.

The deposition apparatus 10 also includes a heating source 18 that is operative to heat a heating zone 20 within the preheating chamber 16 that receives the workpieces 12. For instance, the heating zone 20 is the spatial volume within the preheating chamber 16 where the workpieces 12 will be preheated to provide a thermally grown oxide prior to coating.

As illustrated in Figure 1, a thermal hood 22 (not shown in Figure 2) is located within the preheating chamber 16 adjacent to the heating zone 20 and is operative to control the temperature of the heating zone 20, as will be discussed in more detail below.

In the illustrated example, the deposition apparatus 10 also includes additional features for implementing a coating process. It is to be understood, however, that these other features may be excluded or may vary according to the type of deposition apparatus or other factors. In this regard, the deposition apparatus 10 may include a pump 30 that circulates a coolant, such as water, through walls of the deposition apparatus 10 to control the temperature of the walls during a coating process.

The deposition apparatus 10 may also include a load-lock chamber 32 that is located adjacent to the preheating chamber 16. The load-lock chamber 32 serves as a staging area for mounting the workpieces 12 on an appropriate fixture for the coating process. The fixture may be carried on a transport 34 (shown in part) that is operative to move back and forth through the load-lock chamber 32, the preheating chamber 16, and the coating chamber 14. For example, one or more workpieces 12 may be mounted on the fixture that is attached to the transport for manual or automatic movement between the chambers.

The coating chamber 14 generally includes a coating zone 40 that is the spatial volume within the coating chamber 14 where one or more workpieces may be coated. The coating chamber 14 also includes at least one electron beam source 42. Additional electron beam sources (shown in dashed lines) may also be used. The electron beam sources 42 may be mounted using known techniques to the walls of the coating chamber 14 or mounted adjacent to the walls.

A crucible 44 is located adjacent to the coating zone 40 for presenting a source coating material 46 in a known manner. As an example, the source coating material 46 may be an ingot of metallic or ceramic material that will later be melted and evaporated using electron beams 42a emitted from the electron beam source 42. A tray 48 may be located on the bottom of the coating chamber 14 for holding a ceramic media 50. The ceramic media 50 may be used during a coating process to heat the workpieces 12 by directing the electron beams 42a onto the ceramic media 50.

The deposition apparatus 10 also may include baffles 51 to separate the coating chamber 14 from the preheating chamber 16. A gate valve 52 may extend between the baffles 51 to seal the interior of the coating chamber 14 from the interior of the preheating chamber 16. Likewise, the deposition apparatus 10 may include baffles 54 between the preheating chamber 16 and the load-lock chamber 32.

The preheating chamber 16 may include at least one electron beam source 56 for emitting electron beams 56a. One or more additional electron beam sources 56 (shown in dashed lines) may also be used. The electron beam sources 56 may be mounted to using known techniques to the walls of the preheating chamber 16 or mounted adjacent to the walls.

The heating source 18 is located within the preheating chamber 16 for heating the workpieces 12 to a predetermined temperature. For instance, to facilitate good adhesion of thermal barrier coatings to the workpieces 12, the temperature of the workpieces 12 may be tightly controlled. To this end, the heating source 18 may include a ceramic media 60 for generating radiant heat, as will be discussed below.

The ceramic media 60 may be any type of ceramic media that radiates heat upon being heated. As an example, the ceramic media 60 may include particles of a ceramic material in a water-cooled tray 62. In one example, the ceramic material composition is equivalent to the ceramic material composition that will be used for the coating deposited onto the workpieces 12. Using a ceramic media 60 that is compositionally equivalent to the coating thereby avoids contaminating the workpieces 12 with foreign substances that might evaporate during the preheating cycle and condense onto the surfaces of the workpieces 12.

The thermal hood 22 is located adjacent to the heating zone 20 and may be mounted to the walls of the preheating chamber 16 using brackets 64, for example. Alternatively, the thermal hood 22 may be mounted through the walls of the preheating chamber 16 to an outside support, supported on the fixture that supports the workpieces 12, supported on a stand within the preheating chamber 16 or mounted in any other suitable manner.

The thermal hood 22 may be made of any of a variety of different materials for withstanding the conditions within a preheating chamber 16. For instance, the thermal hood 22 may be made of a solid, continuous piece of nickel-based alloy material or ceramic material to withstand temperatures over 1800°F (982°C) during the preheating process and effectively deflect heat. Given this description, one of ordinary skill in the art will recognize other types of suitable materials for the thermal hood 22.

In this example, the thermal hood 22 at least partially surrounds the heating zone 20. That is, the thermal hood 22 wraps circumferentially at least part way around the perimeter of the heating zone 20. The extent that the thermal hood wraps around the perimeter may vary in other examples, but in some examples, the thermal hood wraps approximately 180 degrees around the perimeter of the heating zone 20.

As illustrated in Figure 3, the thermal hood 22 may include a convex outer surface 70 that faces in a direction away from the heating zone 20 and a concave inner surface 72 that faces in a direction toward the heating zone 20. For example, the thermal hood 22 may be a semi-cylindrical shape relative to a central longitudinal axis A. However, the thermal hood 22 may alternatively have another curved shape that is not semi-cylindrical. In any case, the thermal hood 22 is shaped to deflect heat from the heat source 18 toward the heating zone 20. In this regard, the exemplary semi-cylindrical shape of the thermal hood 22 provides the benefit of effectively deflecting the heat toward the heating zone 20.

In operation, one or more workpieces 12 may be mounted on a fixture in the load-lock chamber 32 and then moved into the preheating chamber 16 using the transport 34. The preheating chamber 16 may be used to heat the workpieces 12 to a temperature desired for forming a desired type of thermally grown oxide on the workpieces 12. As an example, alpha alumina thermally grown oxide may be one preferred type of oxide for facilitating bonding of the coating to the workpieces 12.

Once the workpieces 12 are moved into the heating zone 20, the electron beam sources 56 may be activated to emit the electron beams 56a onto the ceramic media 60. The electron beams 56a heat the ceramic media 60 and produce radiant heat 80. The thermal hood 22 collects the radiant heat 80 within the heating zone 20 to uniformly heat the workpieces 12. For instance, the concave inner surface 72 of the thermal hood 22 deflects the radiant heat 80 from the ceramic media 60 toward the heating zone 20 and limits heat loss through the walls of the preheating chamber 16. Thus, the workpieces 12 are heated in one direction from the ceramic media 60 and in another direction from the deflected radiant heat. In this manner, the thermal hood 22 provides rapid and controlled heating of the workpieces 12 to a predetermined temperature. As can be further appreciated, the shape of the thermal hood 22 may influence the heat-collecting effectiveness. For instance, the extent that the thermal hood 22 wraps around the perimeter of the heating zone 20 may influence the amount of heat collected. That is, a relatively greater degree of wrapping may collect more heat than a relative lesser degree of wrapping.

In some examples, the thermal hood 22 provides the benefit of enabling a user to establish a temperature variation across the heating zone 20 to a variation of less than 1 percent from a predetermined target temperature. Thus, the workpieces 12 and the heating zone 20 do not vary in temperature by more than 1 percent from the target temperature. Additionally, using the thermal hood 22 to control temperature reduces the burden on the electron beam sources 56 of controlling the temperature. Therefore, the thermal hood 22 may also allow greater dedication of the operating parameters of the electron beam sources 56 for effectively or efficiently heating the ceramic media 60.

After production of the thermally grown oxide in the preheating chamber 16, the transport 34 moves the workpieces 12 into the coating chamber 14. As is generally known, the electron beam sources 42 may emit the electron beams 42a onto the source coating material 46 to melt and vaporize the source coating material 46 to deposit the coating onto the workpieces 12.

Optionally, a screen 66 (Figure 1) may be mounted between the thermal hood 22 and the heating zone 20. For instance, the screen 66 may have a porous mesh structure made of wires of a high temperature material, such as a metallic alloy. As an example, the screen 66 may be formed from a nickel-based alloy. The screen 66 may catch material that detaches and falls from the thermal hood 22 and thereby prevent the material from interfering with the preheating process. The screen 66 may be cleaned or changed periodically if debris builds up.

The thermal hood 22 may provide an additional benefit when used in relatively elevated operating pressures. For example, higher pressures within the preheating chambers 16 attenuate the electron beams 56a, thereby making the electron beams 56a less effective to heat the ceramic media 60. One option to compensate for the attenuation is to increase beam electric current; however, doing so may increase the operating expense. By providing rapid and uniform heating, the thermal hood 22 may effectively lower the operating expense by reducing the need to compensate for the attenuation.

Additionally, preheating the workpieces 12 in the preheating chamber, separate from the coating chamber 14, facilitates reducing premature evaporation of the coating material. As an example, preheating that is conducted in a coating chamber prior to deposition of the coating can heat the source coating material and cause low levels of the coating material to evaporate and condense onto the workpieces prior to the coating process. By conducting the preheating separately in the preheating chamber 16 and then moving the workpieces into the coating chamber 14, premature deposition of the coating material onto the workpieces 12 is avoided.

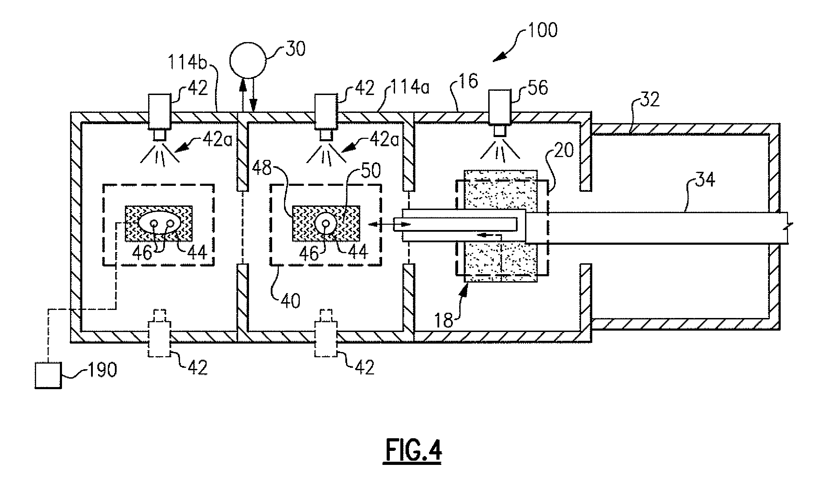

Figure 4 illustrates another embodiment deposition apparatus 110 that is somewhat similar to the deposition apparatus 10. In this disclosure, like reference numerals designate like elements where appropriate, and reference numerals with the addition of one hundred or multiples thereof designate modified elements that are understood to incorporate the same features and benefits of the corresponding original elements. In this example, the deposition apparatus 110 includes a first coating chamber 114a and a second coating chamber 114b. The first coating chamber 114a is similar to the coating chamber 14 of Figure 2. The second coating chamber 114b is also similar to the coating chamber 14 but is adapted for a different type of deposition process than the coating chamber 114a. In this case, the coating chamber 114b is adapted for EB-DVD and includes one or more ingots of source coating material within a crucible 44 for deposition onto the workpieces 12. The crucible 44 is connected to a gas source 190 for providing a carrier gas to facilitate deposition of the coating material. In other words, the first coating chamber 114a is adapted for a first type of coating process, such as conventional EB-PVD and the second coating 114b is adapted for a second type of coating process, such as EB-DVD. In some examples, the second coating chamber 114b may be used to deposit the coating on difficult to coat surfaces, such as non-line-of-site surfaces or surfaces that are severely angled relative to the source coating material. The first coating chamber 114a may be used to deposit another coating layer on the remaining surfaces of the workpieces, such as line-of-site surfaces. Alternatively, the first coating chamber 114a may be adapted for EB-DVD and the second coating 114b may be adapted for EB-PVD, or both chambers 114a, 114b may be adapted for EB-PVD.

Although a combination of features is shown in the illustrated examples, not all of them need to be combined to realize the benefits of various embodiments of this disclosure. In other words, a system designed according to an embodiment of this disclosure will not necessarily include all of the features shown in any one of the Figures or all of the portions schematically shown in the Figures. Moreover, selected features of one example embodiment may be combined with selected features of other example embodiments.

The preceding description is exemplary rather than limiting in nature. Variations and modifications to the disclosed examples may become apparent to those skilled in the art that do not necessarily depart from the essence of this disclosure. The scope of legal protection given to this disclosure can only be determined by studying the following claims.

## Claims

1. A deposition apparatus (10) comprising:
a coating chamber (14) operative to deposit a coating on workpieces (12);
a preheating chamber (16) adjacent the coating chamber, the preheating chamber (16) including a heating zone (20) receiving the workpieces (12);
a heating source (18) operative to provide heat to the heating zone (20); and
a thermal hood (22) within the preheating chamber (16) adjacent to the heating zone (20) and operative to control a temperature of the heating zone.

2. The deposition apparatus as recited in claim 1, wherein the thermal hood (22) at least partially surrounds the heating zone (20).

3. The deposition apparatus as recited in claim 1 or 2, wherein the thermal hood (22) is curved.

4. The deposition apparatus as recited in claim 2 or 3, wherein the thermal hood (22) includes a curved surface (72) adjacent to the heating zone (20).

5. The deposition apparatus as recited in any preceding claim, wherein the thermal hood (22) is semi-cylindrical.

6. The deposition apparatus as recited in any preceding claim, wherein the thermal hood (22) is a solid and continuous piece.

7. The deposition apparatus as recited in any preceding claim, wherein the thermal hood (22) comprises a nickel-based alloy or a ceramic material.

8. The deposition apparatus as recited in any preceding claim, wherein the heating source (18) comprises a ceramic media (60).

9. The deposition apparatus as recited in claim 8, wherein the preheating chamber (16) includes at least one electron beam source (56) operative for emitting an electron beam (56a) onto the ceramic media (60) to generate radiant heat.

10. The deposition apparatus as recited in claim 8 or 9, wherein the heating zone (20) is located between the ceramic media (18) and the thermal hood (22).

11. The deposition apparatus as recited in claim 8, 9 or 10, wherein the ceramic media (60) includes at least one of zirconia or yttria.

12. The deposition apparatus as recited in any preceding claim, further comprising a screen (66) between the thermal hood (22) and the heating zone (20).

13. A method for use with a deposition apparatus (10), comprising:
controlling a temperature within a heating zone (20) in a preheating chamber (16) of a deposition apparatus using a thermal hood (22) adjacent to the heating zone (20).

14. The deposition method as recited in claim 13, including generating radiant heat (80) by emitting an electron beam (56a) onto a ceramic media (60) within the preheating chamber (16), and optionally including collecting the radiant heat (80) in the heating zone (20) using the thermal hood (22).

15. The deposition method as recited in claim 13 or 14, further comprising establishing a temperature variation of the temperature across the heating zone (20) that is less than 1 % of a predetermined target temperature.
